# EUROPEAN PATENT APPLICATION

(11) **EP 4 818 706 A1**
(43) Date of publication of application: **07.10.2026**
(21) Application number: 25168615.0
(22) Date of filing: 04.04.2025
(51) Int. Cl.: G01R 11/04, G01R 22/06

(54) **ELECTRICITY METER FOR METERING POWER CONSUMPTION OF ELECTRICAL EQUIPMENT**

(71) Applicant: HAGER CONTROLS, 67700 Saverne (FR)
(72) Inventor: CALLEGHER, Alexandre, 67330 Ernolsheim-lès-Saverne (FR); CASTELOT, Geoffrey, 67270 Wilwisheim (FR); GARTISER, Alain, 57400 Sarrebourg (FR); MONIOT, Frédéric, 67200 Strasbourg (FR)
(74) Representative: Hagergroup

(57) **Abstract**

The invention relates to an electricity meter (10) for metering a power consumption of an electrical equipment (100), in more particularly of an electric vehicle supply equipment (EVSE). The electricity meter (10) comprises a meter casing (20), a PCB (30) housed in the meter casing (20), a processing unit (32) soldered to the PCB (30), at least one voltage sensor (34) and at least one current sensor (36) housed in the meter casing (20). A neutral meter connection terminal (38), an input phase meter connection terminal (40, 42, 44) and an output phase meter connection terminal (41, 43, 45) of the electricity meter (10) are configured to be connected to a neutral connection terminal (138), an input phase connection terminal (140, 142, 144) and an output phase connection terminal (141, 143, 145) of the electrical equipment (100) respectively by a linear motion of the electricity meter (10) in an engagement direction (ED).

## Description

### FIELD OF THE DISCLOSURE

The present disclosure relates to a system and method for metering electrical power consumption, specifically designed for integration within electrical equipment such as electric vehicle supply equipment (EVSE). The disclosure particularly focuses on an electricity meter configured for linear engagement with the connection terminals of the host equipment, facilitating efficient installation and accurate measurement of single-phase or three-phase power consumption.

### BACKGROUND OF THE INVENTION

In the field of electricity metering, it is common to use devices that measure power consumption for various types of electrical equipment, including electric vehicle supply equipment (EVSE). Known systems typically involve complex installation procedures that require precise alignment and connection of multiple terminals. These systems often necessitate specialized tools and skilled personnel to ensure proper installation and functionality. Additionally, the integration of electricity meters into electrical equipment can be cumbersome, leading to increased installation time and potential errors.

According to known approaches, electricity meters are often housed separately from the electrical equipment they monitor and require extensive wiring and configuration to achieve accurate power measurement. However, the connection terminals in existing systems may not be designed for easy engagement, leading to difficulties in achieving reliable electrical connections. An example of such a separately housed electricity meter is given in WO 2024/173864 A1. The electricity meter is installed by feeding input blades through the openings of current transformer coils of the meter. This can compromise the accuracy of the power consumption data and affect the overall performance of the metering system.

Despite the substantial advances in the field of electricity metering, there remains a need for improved systems that simplify the installation process and enhance the reliability of electrical connections. Current solutions often lack the ability to seamlessly integrate the meter with the electrical equipment, resulting in potential misalignment and connectivity issues. Additionally, the physical design of existing meters may not be optimized for ease of installation, requiring significant effort to achieve proper engagement and secure connections.

It is therefore a technical problem underlying the present invention to provide an electricity metering system that at least partially overcomes the disadvantages of known systems.

### SUMMARY OF THE DISCLOSURE

It is an object of this invention to provide a system that overcomes one or more of the disadvantages of known systems.

A first aspect of the invention provides an electricity meter for metering a single phase power consumption or a three-phase power consumption of an electrical equipment, more particularly of an electric vehicle supply equipment (EVSE). The electricity meter is configured to be installed in a receiving section of the electrical equipment and comprises a meter casing, a printed circuit board (PCB) housed in the meter casing, a processing unit soldered to the PCB, at least one voltage sensor housed in the meter casing, at least one current sensor housed in the meter casing, a neutral meter connection terminal configured to be connected to a neutral connection terminal of the electrical equipment , at least one input phase meter connection terminal configured to be connected to an input phase connection terminal of the electrical equipment and at least one output phase meter connection terminal configured to be connected to an output phase connection terminal of the electrical equipment, characterized in that the neutral meter connection terminal, the input phase meter connection terminal and the output phase meter connection terminal are configured to be connected to the neutral connection terminal, the input phase connection terminal and the output phase connection terminal of the electrical equipment respectively by a linear motion of the electricity meter in an engagement direction towards the receiving section.

According to a preferred embodiment, the electricity meter is designed for measuring the power consumption of the electrical equipment, specifically tailored for electric vehicle supply equipment (EVSE). This electricity meter is intended to be installed within a designated receiving section of the electrical equipment. The electricity meter comprises several components, including the meter casing that houses the printed circuit board (PCB). The PCB is equipped with the processing unit that is soldered onto it, which is responsible for processing the data collected by the meter and/or the electrical parameters measured by the current sensor and/or the voltage sensor.

The neutral meter connection terminal of the electricity meter is designed to be connected to the neutral connection terminal of the electrical equipment. It also includes at least one input phase meter connection terminal and at least one output phase meter connection terminal, which correspond to the input and output phase connection terminals of the electrical equipment. These terminals facilitate the connection of the meter to the electrical equipment.

In a single-phase configuration, the electricity meter includes one input phase meter connection terminal and one output phase meter connection terminal. In a three-phase configuration, the electricity meter includes three input phase meter connection terminals and three output phase meter connection terminals.

The electricity meter may be submitted for approval or compliance (e.g., MID compliance) independently of the electrical equipment. Once it is approved, it can be installed into the electrical equipment, more particularly the EVSE. In an embodiment, the meter housing may provide tamper protection. For instance, the tamper detection may detect if the meter housing is opened.

The distinguishing characteristic of this electricity meter is that the neutral meter connection terminal, the input phase meter connection terminals, and the output phase meter connection terminals are configured to connect to their respective terminals on the electrical equipment through a linear motion. This linear motion occurs in an engagement direction towards the receiving section of the electrical equipment, simplifying the installation process and ensuring a secure connection.

The advantages of this configuration include a streamlined and efficient installation process, reducing the complexity and time required to connect the electricity meter to the electrical equipment. This design also enhances the reliability and stability of the connections, minimizing the risk of loose or faulty connections that could affect the accuracy of the power consumption measurements.

In a preferred embodiment of the first aspect, the receiving section of the electrical equipment comprises a receiving surface. The meter casing comprises a support section configured to rest against the receiving surface when the electricity meter is installed in the receiving section, the meter casing preferably comprising a back surface from which the support section protrudes in the engagement direction, the engagement direction being substantially orthogonal to the receiving surface and/or the back surface.

This embodiment focuses on the interaction between the meter casing and the receiving section of the electrical equipment. Specifically, the receiving section includes the receiving surface, and the meter casing is characterized by the support section that is configured to rest against this receiving surface when the meter is installed. This support section protrudes from the back surface of the meter casing in the engagement direction, which is substantially orthogonal to both the receiving surface and the back surface. The introduction of the support section and its interaction with the receiving surface enhances the stability and alignment of the electricity meter during installation, ensuring that the linear motion required for connection is precisely guided and maintained. This feature not only facilitates a more secure and reliable connection between the meter and the electrical equipment but also simplifies the installation process by providing a clear physical guide for the engagement direction. The orthogonal alignment of the engagement direction relative to the receiving surface and the back surface further ensures that the meter is positioned correctly and securely, minimizing the risk of misalignment or improper connection that could affect the meter's performance. By incorporating these structural features, the preferred embodiment adds a layer of mechanical precision and ease of use to the electricity meter, enhancing its functionality and reliability in practical applications. This preferred embodiment underscores the importance of mechanical design in ensuring the effective operation of electronic components, particularly in environments where precise alignment and secure connections are critical for optimal performance.

In a further preferred embodiment of the first aspect, the electricity meter comprises a data connection interface configured to be connected to a data connection interface of the electrical equipment by the same linear motion of the electricity meter in the engagement direction towards the receiving section.

These additional features introduce a streamlined and efficient mechanism for establishing communication between the electricity meter and the electrical equipment. The meter data connection interface, preferably located on the back surface of the meter casing, ensures that data transmission can occur seamlessly as the meter is installed. This arrangement simplifies the installation process, as it eliminates the need for separate actions to connect the data interfaces, thereby reducing the potential for errors and ensuring a more reliable connection. The linear motion mechanism for connecting the data interfaces is consistent with the motion used to connect the neutral and phase meter connection terminals to their respective terminals on the electrical equipment. This uniformity in the engagement process provides a straightforward and intuitive method for installing the electricity meter, which is particularly beneficial in environments where quick and accurate installation is critical, such as in electric vehicle supply equipment. The inclusion of the meter data connection interface also facilitates the transmission of metering data, which can be used for monitoring and managing power consumption. This capability is beneficial for applications that require precise and real-time data analysis, enabling better control and optimization of power usage. Additionally, the positioning of the meter data connection interface on the back surface of the meter casing ensures that the interface is protected and less likely to be damaged during installation or operation. This design consideration contributes to the durability and longevity of the electricity meter, making it a reliable component in the electrical equipment. Overall, the introduction of the meter data connection interface enhances the functionality and usability of the electricity meter, providing a comprehensive solution for metering and data communication in single-phase or three-phase power consumption scenarios.

In a further preferred embodiment of the first aspect, the neutral meter connection terminal, the input phase meter connection terminal and the output phase meter connection terminal are housed in the meter casing.

This arrangement within the meter casing brings several advantages and new features to the electricity meter. Firstly, by housing these connection terminals within the casing, the design enhances the compactness and integrity of the meter, potentially reducing the risk of exposure to external environmental factors such as dust, moisture, or mechanical damage, which could otherwise affect the performance or longevity of the meter. Secondly, the integration of these terminals within the casing may simplify the installation process, as the linear motion required for engagement is streamlined by having all necessary connection points contained within a single housing unit. This could lead to quicker and more efficient installation, reducing labor costs and time required for setup. Furthermore, having the terminals housed within the casing may improve the overall aesthetic and ergonomic design of the meter, making it more appealing for use in consumer-facing applications such as electric vehicle charging stations. The internal housing of these terminals may also facilitate better thermal management and electrical insulation, as the casing can be designed to optimize heat dissipation and minimize electrical interference between components. Additionally, this configuration may enhance the safety features of the meter by reducing the likelihood of accidental contact with live terminals during installation or maintenance. Overall, the housing of the connection terminals within the meter casing represents a significant improvement in the design and functionality of the electricity meter, offering benefits in terms of protection, ease of installation, aesthetic appeal, thermal management, and safety.

In a further preferred embodiment of the first aspect, the meter casing, preferably the back surface of the meter casing, comprises at least one opening configured to be penetrated by at least one of the neutral connection terminal, the input phase connection terminal and/or the output phase connection terminal of the electrical equipment when the electricity meter is installed in the receiving section, the neutral meter connection terminal, the input phase meter connection terminal and the output phase meter connection terminal being configured to be electrically connected to the neutral connection terminal, the input phase connection terminal and the output phase connection terminal of the electrical equipment respectively when the electricity meter is installed in the receiving section.

According to this preferred embodiment, the meter casing may comprise multiple openings, more particularly a separate opening for each neutral meter connection terminal, input phase meter connection terminal and output phase meter connection terminal.

According to this preferred embodiment, the electricity meter is designed to facilitate efficient and secure installation within the receiving section of an electrical equipment, particularly an electric vehicle supply equipment. the opening(s) of the meter casing is/are strategically positioned to allow penetration by the neutral connection terminal, the input phase connection terminals, and the output phase connection terminals of the electrical equipment. This design ensures that when the electricity meter is installed, these connection terminals can seamlessly pass through the opening(s) in the meter casing, enabling a straightforward and reliable connection. The neutral meter connection terminal, input phase meter connection terminals, and output phase meter connection terminals are configured to establish an electrical connection with their corresponding terminals on the electrical equipment upon installation. This feature enhances the ease of installation by allowing the connection terminals of the electrical equipment to penetrate the meter casing openings, thereby aligning and connecting with the meter's terminals through a linear motion in the engagement direction. The new feature of having openings in the meter casing for the connection terminals to penetrate brings several advantages. Firstly, it simplifies the installation process by providing a clear and direct path for the terminals to connect, reducing the likelihood of misalignment or improper connections. Secondly, it enhances the reliability of the electrical connections by ensuring that the terminals are securely engaged and properly aligned, which allows for accurate metering and safe operation. Thirdly, this design can potentially reduce the time required for installation and maintenance, as the openings provide easy access to the connection points. Additionally, the feature of having the neutral meter connection terminal, input phase meter connection terminals, and output phase meter connection terminals configured for electrical connection upon installation ensures that the meter is ready for immediate operation once installed, without the need for additional adjustments or configurations. This embodiment addresses the need for a user-friendly and efficient installation process while maintaining the integrity and accuracy of the electricity meter's connections, thereby enhancing the overall functionality and usability of the meter within various electrical equipment applications.

In a further preferred embodiment, the neutral meter connection terminal, the input phase meter connection terminal and/or the output phase meter connection terminal is/are formed as crown spring connector.

The specific use of crown spring connectors is designed to provide reliable and efficient electrical connections through a spring-loaded mechanism. This feature introduces several advantages, including enhanced contact stability and reduced risk of disconnection due to vibrations or mechanical stresses. Crown spring connectors are known for their ability to maintain consistent electrical contact even under varying environmental conditions, which is particularly beneficial for applications involving electric vehicle supply equipment that may be subject to changes in the environmental conditions. Additionally, the use of crown spring connectors simplifies the installation process by allowing for straightforward linear engagement, thereby reducing the complexity and time required for connecting the electricity meter to the electrical equipment. This improvement in connector design ensures that the electricity meter can be securely and efficiently integrated into the receiving section of the electrical equipment, providing reliable metering of power consumption. Furthermore, the crown spring connectors contribute to the overall durability and longevity of the electricity meter by minimizing wear and tear on the connection points, which can be a critical factor in maintaining accurate and consistent metering performance over extended periods.

In a further preferred embodiment, the PCB comprises at least three orifices configured to be penetrated by the neutral connection terminal, by the input phase connection terminal and/or by the output phase connection terminal of the electrical equipment when the electricity meter is installed in the receiving section. In a single-phase configuration, the PCB may comprise three orifices, one to be penetrated by the neutral connection terminal, one to be penetrated by the input phase connection terminal and one to be penetrated by the output phase connection terminal. In a three-phase configuration, the PCB may comprise seven orifices, one to be penetrated by the neutral connection terminal, three to be respectively penetrated by one of the three input phase connection terminals and three to be respectively penetrated by one of the three output phase connection terminals.

This preferred embodiment ensures a secure and stable electrical connection and brings enhanced reliability and ease of installation to the electricity meter, as the orifices in the PCB provide precise alignment and secure engagement of the connection terminals. This design minimizes the risk of misalignment or poor contact, which can lead to inaccurate metering or potential electrical faults. Additionally, the penetration of the connection terminals through the PCB orifices facilitates a more compact and integrated assembly, reducing the overall size and complexity of the electricity meter. This streamlined configuration is particularly advantageous for installations in confined spaces or where space optimization is critical, as in the EVSE. Furthermore, the orifices in the PCB contribute to the robustness of the electricity meter by providing mechanical support to the connection terminals, thereby reducing the likelihood of terminal movement or disconnection due to vibrations or external forces. This embodiment underscores the importance of precise mechanical design in ensuring the reliable operation and longevity of the electricity meter, particularly in demanding applications such as electric vehicle supply equipment.

In a further preferred embodiment, the input phase meter connection terminal and/or the output phase meter connection terminal is/are positioned coaxially with the corresponding orifice. This coaxial positioning ensures precise alignment and facilitates seamless connectivity between the electricity meter and the electrical equipment. The new feature of coaxial positioning brings several advantages, including enhanced accuracy in the alignment of terminals, which reduces the risk of misconnection and potential damage to the components. It also simplifies the installation process, making it more intuitive and less prone to errors. Furthermore, the coaxial arrangement contributes to the robustness of the connection, ensuring stable and reliable electrical contact, which allows for accurate metering and long-term performance of the electricity meter. This design consideration improves the overall efficiency and reliability of the electricity meter, providing a more user-friendly and dependable solution for metering power consumption in various electrical equipment, including EVSE.

In a further preferred embodiment of the first aspect, the neutral meter connection terminal, the input phase meter connection terminal and/or the output phase meter connection terminal protrude(s) through its/their corresponding orifice(s).

The configuration according to this embodiment enhances the connectivity and integration of its components within the electrical equipment, particularly focusing on the neutral meter connection terminal, the input phase meter connection terminal, and the output phase meter connection terminal. These terminals are engineered to protrude through their corresponding orifices, which facilitates a streamlined and efficient connection process. The protrusion feature of the terminals through their respective orifices ensures a secure and reliable connection. This design allows for a more straightforward installation process, as the protruding terminals can be easily aligned and inserted into their corresponding orifices, reducing the risk of misalignment and ensuring a stable electrical connection. The protrusion of the terminals through the orifices also provides a physical guide that aids in the precise positioning of the electricity meter within the receiving section of the electrical equipment. This feature is particularly beneficial in environments where space is limited or where the installation process needs to be expedited without compromising the integrity of the connection. Furthermore, the protruding terminals enhance the mechanical stability of the electricity meter once installed, as they provide additional points of contact and support within the receiving section. This not only improves the durability of the connection but also minimizes the potential for disconnection due to vibrations or external forces. The ability of the terminals to protrude through their corresponding orifices also facilitates better heat dissipation and airflow around the connection points, which can contribute to the overall thermal management of the electricity meter and the electrical equipment. This is especially important in applications where the electricity meter is subject to high power loads or extended periods of operation. By incorporating these features, the electricity meter offers improved performance and reliability, making it a suitable choice for metering power consumption in various types of electrical equipment, including electric vehicle supply equipment. This embodiment highlights the importance of thoughtful design in enhancing the functionality and usability of electrical components, ensuring that they meet the demands of modern electrical systems while providing ease of installation and maintenance.

In a further preferred embodiment of the first aspect, the neutral meter connection terminal, the input phase meter connection terminal and/or the output phase meter connection terminal is/are soldered to the PCB on a side of the PCB facing away from the back surface and/or facing away from the receiving surface of the electrical equipment.

This preferred embodiment brings several advantages to the electricity meter's design and functionality. By soldering the connection terminals to the PCB on the side facing away from the back surface and/or the receiving surface, the structural integrity and stability of the connections are enhanced, reducing the likelihood of disconnections or faults due to mechanical stress or vibrations during installation and operation. This configuration also facilitates a more compact and streamlined design, allowing for easier integration into the receiving section of the electrical equipment without compromising the accessibility or functionality of the connection terminals. Additionally, this arrangement can improve the overall durability and reliability of the electricity meter, ensuring consistent and accurate metering of power consumption over extended periods. The soldering of the terminals on the specified side of the PCB can also simplify the manufacturing process, potentially reducing production costs and time while maintaining high-quality standards. Furthermore, this design consideration can lead to better thermal management within the meter casing, as the placement of the terminals away from the back surface and receiving surface may allow for more efficient heat dissipation, thereby enhancing the performance and longevity of the electronic components housed within the meter casing. Overall, the new feature introduced in the embodiment significantly contributes to the robustness, efficiency, and practicality of the electricity meter, making it a more reliable and effective solution for metering power consumption in various electrical equipment applications, particularly in electric vehicle supply equipment.

In a further preferred embodiment of the first aspect, the electricity meter comprises a screen configured to display the power consumption, the screen being arranged on the meter casing.

This preferred embodiment introduces a visual interface directly on the electricity meter, allowing users to monitor power consumption without needing external devices or interfaces. Power consumption is typically displayed as an amount of energy delivered during a given period of time and is expressed in kilowatt-hours (kWh). The integration of the screen into the meter casing enhances user interaction by providing immediate feedback on power usage, which can be particularly useful for managing energy consumption in applications such as electric vehicle supply equipment. The screen's placement on the meter casing ensures that it is easily accessible and visible, facilitating quick and convenient monitoring. It also allows for a testing of the electricity meters' functionality prior to its installation in the electrical equipment. This embodiment leverages the processing unit soldered to the PCB, which processes the data from the voltage and current sensors housed in the meter casing. The processing unit calculates the power consumption and transmits this information to the screen for display. The communication between the processing unit and the screen is likely facilitated through direct electrical connections on the PCB, ensuring efficient and reliable data transfer. The inclusion of the screen also implies that the electricity meter has a user interface component, which may involve additional elements such as buttons or touch-sensitive areas for navigating different display modes or settings. This enhancement brings a new level of functionality to the electricity meter, making it more user-friendly and informative. It transforms the electricity meter from a mere measurement device to an interactive tool that provides valuable insights into power consumption patterns. This can help users make informed decisions about their energy usage, potentially leading to more efficient and cost-effective operation of electrical equipment. Furthermore, the screen's ability to display power consumption in real-time can be beneficial for applications where immediate feedback is necessary, such as in dynamic load management scenarios or when troubleshooting electrical systems. Overall, the addition of the screen configured to display power consumption significantly enriches the feature set of the electricity meter, enhancing its utility and user experience.

In a further preferred embodiment, the current sensor is an ammeter shunt.

According to this preferred embodiment, the current sensor is specifically characterized as an ammeter shunt, which introduces a precise mechanism for measuring current. The ammeter shunt operates by creating a low-resistance path for the current to flow through, allowing the voltage drop across the shunt to be measured. This voltage drop is directly proportional to the current flowing through the shunt, enabling accurate current measurement. The integration of an ammeter shunt as the current sensor enhances the electricity meter's ability to provide precise and reliable current readings, which is beneficial for accurate power consumption metering. The use of an ammeter shunt also offers advantages such as reduced power loss and improved thermal stability compared to other types of current sensors, such as Hall effect sensors or current transformers. This feature brings a significant improvement in the overall performance of the electricity meter, ensuring that it can handle varying current loads with high accuracy and reliability. Additionally, the ammeter shunt's compact design allows for efficient utilization of space within the meter casing, contributing to the overall compactness and ease of installation of the electricity meter within the receiving section of the electrical equipment.

A second aspect of the invention provides an electrical equipment, more particularly an electric vehicle supply equipment comprising an electricity meter according to the first aspect, a receiving section, a neutral connection terminal, at least one input phase connection terminal and at least one output phase connection terminal, the electricity meter being installed in the receiving section, the neutral meter connection terminal of the electricity meter being connected to the neutral connection terminal, the input phase meter connection terminal of the electricity meter being connected to the input phase connection terminal and the output phase meter connection terminal of the electricity meter being connected to the output phase connection terminal.

According to the second aspect, a linear motion mechanism allows the electricity meter to be engaged with the receiving section of the electrical equipment in a straightforward and efficient manner. This linear motion mechanism simplifies the installation process, reducing the need for complex wiring or additional connectors. The ability to connect the meter to the electrical equipment through a linear motion in an engagement direction ensures that the connections are secure and reliable, minimizing the risk of disconnection or faulty readings. Additionally, this design allows for easy maintenance and replacement of the electricity meter, as it can be quickly disengaged and removed from the receiving section without the need for extensive disassembly. Overall, the second aspect introduces a robust and user-friendly approach to integrating electricity metering capabilities into electrical equipment, particularly electric vehicle supply equipment, thereby enhancing the overall performance and reliability of the system.

In a preferred embodiment of the second aspect, the neutral connection terminal, the input phase connection terminal and the output phase connection terminal are each formed by a connection pin extending in a direction which is parallel to the engagement direction.

This embodiment brings several advantages to the design and functionality of the electricity meter. Firstly, the parallel extension of the connection pins in the engagement direction simplifies the alignment and connection process during installation, reducing the likelihood of misalignment and ensuring a secure and reliable electrical connection. This design can enhance the robustness of the connection, minimizing the risk of disconnection due to vibrations or movement, which is particularly beneficial in applications involving electric vehicles where stability and reliability are important. Moreover, the parallel configuration of the connection pins may facilitate automated or semi-automated assembly processes, potentially reducing manufacturing costs and improving production efficiency. The streamlined installation process can also contribute to reduced labor costs and installation time, making the electricity meter more appealing for commercial applications. Additionally, this design may allow for more compact and space-efficient arrangements within the receiving section, optimizing the use of space and potentially allowing for additional components or features to be integrated into the electrical equipment. Overall, this embodiment enhances the practicality, reliability, and efficiency of the electricity meter's installation and operation, providing tangible benefits in terms of ease of use, manufacturing, and long-term performance.

In a further preferred embodiment of the second aspect, the neutral connection terminal, the input phase connection terminal and the output phase connection terminal are each soldered to a printed circuit board of the electrical equipment.

The terminals according to this embodiment are each soldered to the printed circuit board (PCB) of the electrical equipment, which significantly enhances the structural integrity and electrical conductivity of the connections. The soldering process ensures that the terminals are securely affixed to the PCB, thereby reducing the risk of disconnections or loose contacts that could potentially disrupt the metering process. This method of attachment provides a stable and durable connection that is less susceptible to mechanical stress and vibrations, which are common in electrical equipment environments. The integration of these terminals into the PCB through soldering also facilitates a more compact and streamlined design, allowing for efficient use of space within the meter casing and the receiving section of the electrical equipment. This design approach not only optimizes the physical layout but also improves the overall performance and reliability of the electricity meter. The soldered connections contribute to a more efficient transmission of electrical signals between the meter and the electrical equipment, ensuring accurate and consistent metering of power consumption. Additionally, the soldering technique enhances the thermal management of the PCB, as it provides better heat dissipation compared to other connection methods, thereby prolonging the lifespan of the components and reducing the likelihood of overheating. The embodiment further emphasizes the importance of precise alignment and secure engagement of the meter connection terminals with the corresponding terminals of the electrical equipment, facilitated by the linear motion of the electricity meter in an engagement direction towards the receiving section. This precise alignment ensures that the soldered connections maintain their integrity and functionality, even during installation and operation. Overall, the incorporation of soldered terminals on the PCB of the electrical equipment introduces a new level of reliability, efficiency, and durability to the metering system, addressing potential issues related to mechanical stress, electrical conductivity, and thermal management, thereby enhancing the overall performance and longevity of the electricity meter and the electrical equipment it serves.

### BRIEF DESCRIPTION OF THE DRAWINGS

Figure 1: shows a perspective view of an embodiment of an electricity meter with a meter casing, a screen for displaying power consumption, and connection terminals for phase and neutral connections, configured for linear engagement.
Figure 2: shows a front view of the electricity meter according to the embodiment.
Figure 3: shows a side view the electricity meter according to the embodiment.
Figure 4: shows a back view of the electricity meter according to the embodiment.
Figure 5: shows an exploded view of an electrical equipment comprising the electricity meter according to the embodiment.
Figure 6: shows a cross sectional view of the electricity meter according to the embodiment installed in a receiving section of the electrical equipment.
Figure 7: shows a perspective view of the electricity meter according to the embodiment installed in the receiving section of the electrical equipment.
Figure 8: shows a detailed view of a printed circuit board of the electricity meter according to the embodiment with various connection terminals and sensors arranged thereon.
Figure 9: shows a highly schematic block diagram of the electricity meter according to the embodiment and its connections.

### DETAILED DESCRIPTION OF THE EMBODIMENTS

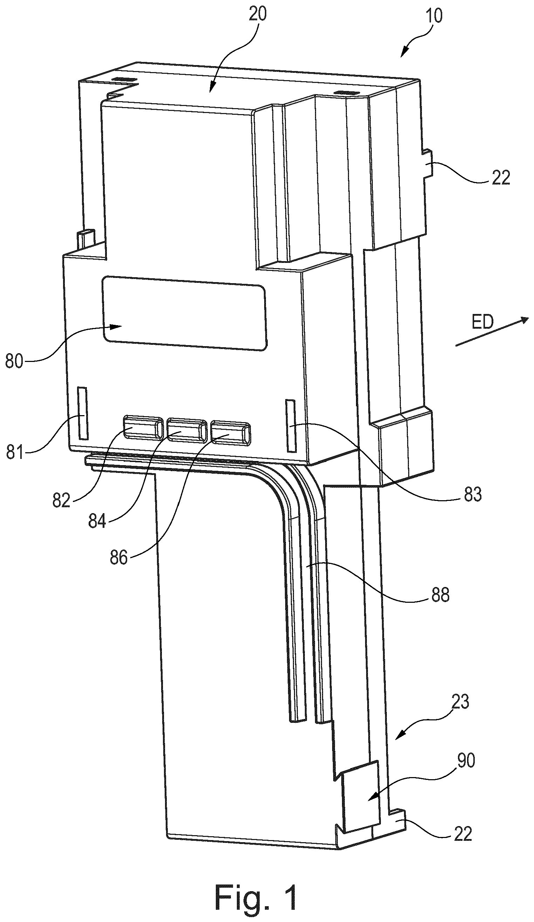

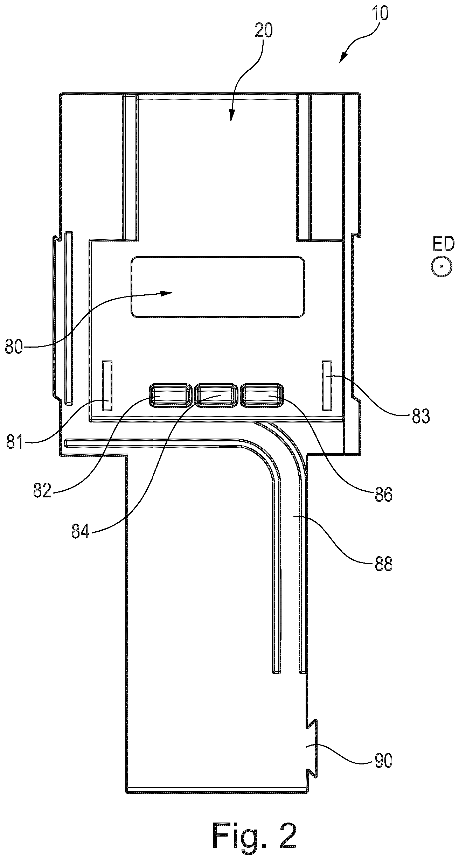

Figures 1 to 4 illustrate an electricity meter 10 according to the embodiment designed for metering power consumption in either single-phase or three-phase electrical systems, specifically tailored for integration with electrical equipment such as electric vehicle supply equipment EVSE. The electricity meter 10 is housed within a meter casing 20, which serves as the protective enclosure for the internal components. The casing 20 is structured to facilitate installation within a designated receiving section of the electrical equipment, aligning with the engagement direction ED.

The meter casing 20 features a support section, which protrudes in the engagement direction ED. Preferably, the support section is formed by a plurality of support feet 22. The support feet 22 may be separated from one another by gaps 23. This support section is configured to rest against a receiving section 120 when the electricity meter 10 is installed, ensuring stability and proper alignment. The engagement direction ED is substantially orthogonal to a receiving surface 122 of the electrical equipment 100, facilitating straightforward linear motion during installation.

The electricity meter 10 further comprises a printed circuit board (PCB) 30 housed in the meter casing 20, a processing unit 32 soldered to the PCB 30, at least one voltage sensor 34 housed in the meter casing 20, at least one current sensor 36 housed in the meter casing 20, a neutral meter connection terminal 38 configured to be connected to a neutral connection terminal 138 of the electrical equipment 100 , at least one input phase meter connection terminal 40, 42, 44 configured to be connected to an input phase connection terminal 140, 142, 144 of the electrical equipment 100 and at least one output phase meter connection terminal 41, 43, 45 configured to be connected to an output phase connection terminal 141, 143, 145 of the electrical equipment 100. The voltage sensor 34 and the current sensor 36 typically provide an analog signal which is representative of the measured voltage and/or current.

The electricity meter 10 may further comprise an analog to digital converter 35 connected to the voltage sensor 34 and the current sensor 36 on the one hand and to the processing unit 32 on the other hand. The analog to digital converter 35 retrieves analog data from the voltage sensor 34 and/or the current sensor 36 and provides a digital representation of the measurements to the processing unit 32. The analog to digital converter 35 is typically also soldered to the PCB 30.

The electricity meter 10 according to the embodiment is a three-phase electricity meter that is configured for metering a three-phase power consumption of the electrical equipment 100. The electricity meter 10 according to the embodiment hence comprises three voltage sensors 34, three current sensors 36, that is one voltage sensor 34 and one current sensor 36 for each phase. The electricity meter 10 according to the embodiment also comprises three input phase meter connection terminal 40, 42, 44 and three output phase meter connection terminals 41, 43, 45.

The electricity meter 10 may be submitted for approval or compliance (e.g., MID compliance) independently of the electrical equipment 100. Once it is approved, it can be installed into the electrical equipment 100, more particularly the EVSE. In a preferred embodiment, the meter housing 20 may provide tamper protection. For instance, the tamper detection may detect if the meter housing 20 is opened.

The front face of the meter casing 20 is equipped with a screen 80, which is designed to display power consumption data of the electrical equipment 100 in real time. The screen 80 provides users with immediate visual feedback regarding the electricity usage of the connected electrical equipment 100. The screen 80 is prominently positioned on the front surface of the meter casing 20, allowing easy visibility for users to monitor power usage.

Below the screen 80, the casing 20 includes several push-buttons 82, 84, and 86. These push-buttons 82, 84, 86 allow the input of commands to the electricity meter 10, more particularly commands to toggle between different data to be displayed on the screen 80. For instance, the different data to be displayed can be the momentary voltage on a particular phase, momentary current on a particular phase, the momentary active energy for a particular phase, the momentary active energy for all phases combined, the momentary active power and/or the momentary reactive power. Additional data can be the serial number of the electricity meter, the date and/or the year of the calibration of the electricity meter, the version number of the software running on the processing unit 32, etc.. Furthermore, LEDs 81 and 83 are present to indicate operational status of the electricity meter 10 and provide visual feedback to the user

Additionally, the figure depicts a cable conduit 88 extending from the lower portion of the casing 20. This cable conduit 88 facilitates electrical connections between an auxiliary data interface 62 of the electricity meter 10 and an auxiliary device of the electricity meter 10, ensuring the transmission of data signals between the electricity meter 10 and the auxiliary device.

The casing 20 is further detailed with an attachment portion 90, which is configured to receive the auxiliary device. This ensures that auxiliary device is securely positioned on the casing 20 of the electricity meter 10.

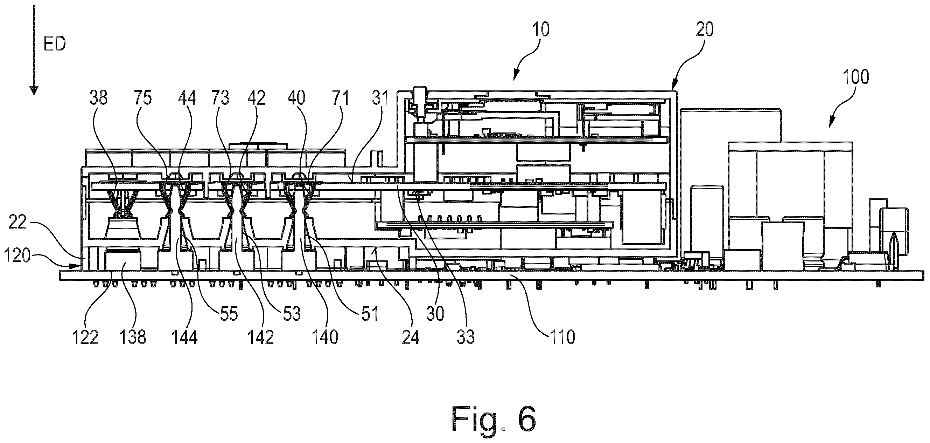

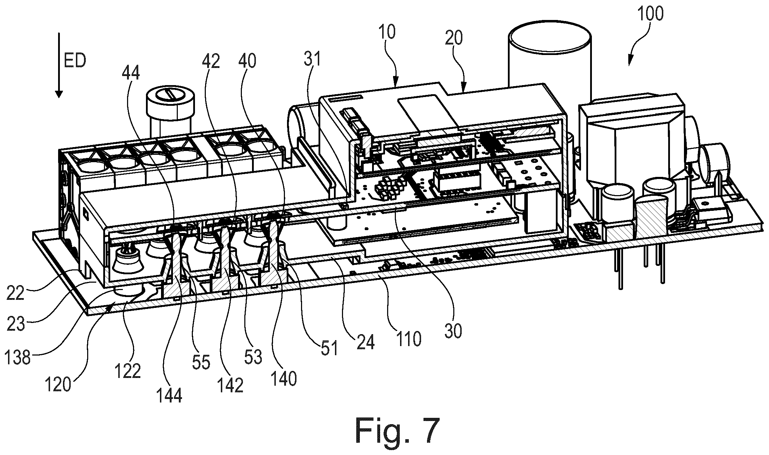

As can be seen in figures 6 and 7 in particular, the printed circuit board PCB 30 of the electricity meter 10 is housed within the meter casing 20. The PCB 30 supports the processing unit 32 and various sensors 34, 36 required for metering power consumption of the electrical equipment 100. The figures indicate that the PCB 30 is positioned such that it aligns with a plane which is perpendicular to the engagement direction ED, facilitating a linear motion for installation into the receiving section 120 of the electrical equipment 100.

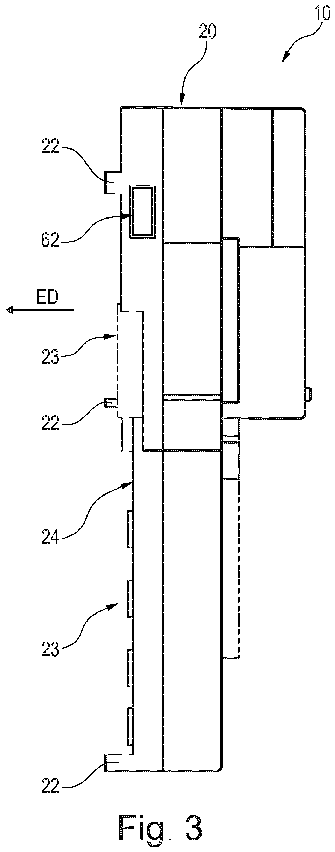

Figure 3 shows a lateral view of the electricity meter 10 according to the embodiment. The support section of the meter housing 20 is formed by the plurality of support feet 22, which are separated from one another by the gaps 23. The support section and/or the support feet 22 is/are configured to rest against the receiving surface 122 when the electricity meter 10 is installed in the receiving section 120 of the electrical equipment 100. The support feet 22protrude from a back surface 24 of the meter casing 20 in the engagement direction ED, which is indicated by an arrow in the figure. The engagement direction ED is substantially orthogonal to the back surface 24, facilitating the linear motion required for installation.

Within the meter casing 20, the auxiliary data interface 62 of the electricity meter 10 is visible. This auxiliary data interface 62is configured to connect to a corresponding data connection interface of the electrical equipment 100.

Figures 1 to 40 emphasize the structural aspects of the meter casing 20, particularly the support feet 22 and the back surface 24, which contribute to the physical stability and alignment of the electricity meter 10 during installation. The support section and/or the support feet 22is/are strategically positioned to provide a stable resting point against the receiving surface 122, ensuring that the electricity meter 10 remains securely attached and properly aligned.

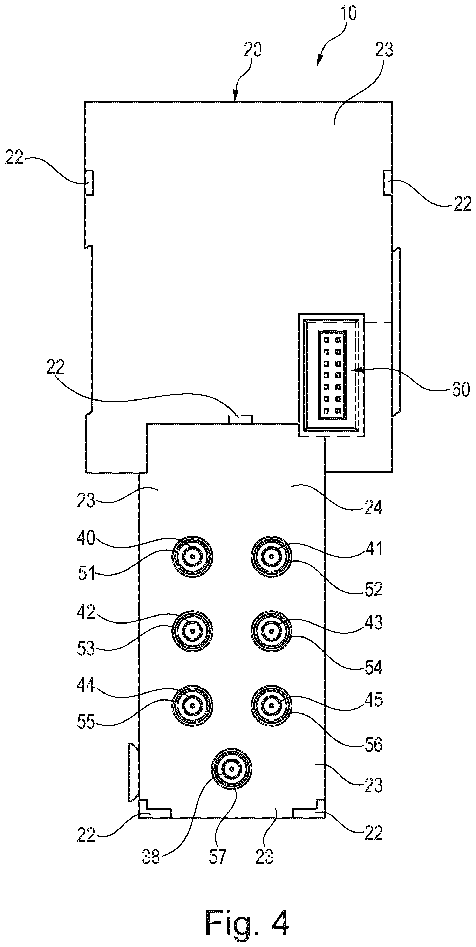

Figure 4 depicts a back view of the electricity meter 10 according to the embodiment. As can be seen in that figure, the electricity meter 10 is equipped with a meter data connection interface 60, which is arranged on the back surface 24. The data connection interface 60 is designed to connect to a corresponding data connection interface 160 of the electrical equipment 100 by the same linear motion in the engagement direction ED, by which the neutral meter connection terminal 38, the input phase meter connection terminal 40, 42, 44 and the output phase meter connection terminal 41, 43, 45 are connected to the neutral connection terminal 138, the input phase connection terminal 140, 142, 144 and the output phase connection terminal 141, 143, 145 of the electrical equipment 100.

The figure shows several connection terminals housed within the meter casing 20.

These include:
- Neutral meter connection terminal 38
- Input phase meter connection terminals 40, 42, 44
- Output phase meter connection terminals 41, 43, 45

Each connection terminal is configured to be connected to corresponding terminals of the electrical equipment 100 by a linear motion towards the receiving section 120. The neutral meter connection terminal 38, input phase meter connection terminals 40, 42, 44, and output phase meter connection terminals 41, 43, 45 are positioned to align with the neutral connection terminal 138, input phase connection terminals 140, 142, 144, and output phase connection terminals 141, 143, 145 of the electrical equipment 100, respectively.

The meter casing 20 features multiple openings 51, 52, 53, 54, 55, 56, 57, which are designed to be penetrated by the corresponding connection terminals 140, 141, 142, 143, 144, 145 of the electrical equipment 100 when the electricity meter 10 is installed. These openings ensure that the neutral meter connection terminal 38, input phase meter connection terminals 40, 42, 44, and output phase meter connection terminals 41, 43, 45 are electrically connected to their respective terminals140, 141, 142, 143, 144, 145 of the electrical equipment 100.

The neutral meter connection terminal 38, input phase meter connection terminals 40, 42, 44, and output phase meter connection terminals 41, 43, 45 are formed as crown spring connectors, providing secure and reliable connections. Each crown spring connector comprises a base in a sleeve shape and a plurality of contacting tongues configured to come in contact with the connection terminals 140, 141, 142, 143, 144, 145 of the electrical equipment 100. The contacting tongues protrude from the base of the crown spring connector and are preferably arranged circumferentially around the base in a funnel shape. Each crown spring connector is designed to provide reliable and efficient electrical connections through a spring-loaded mechanism formed by the contacting tongues. The use of crown spring connectors provides several advantages, including enhanced contact stability and reduced risk of disconnection due to vibrations or mechanical stresses. Crown spring connectors are known for their ability to maintain consistent electrical contact even under varying environmental conditions, which is particularly beneficial for applications involving EVSE that may be subject to changes in the environmental conditions. Additionally, the use of crown spring connectors simplifies the installation process by allowing for straightforward linear engagement, thereby reducing the complexity and time required for connecting the electricity meter 10 to the electrical equipment 100. This improvement in connector design ensures that the electricity meter 10 can be securely and efficiently integrated into the receiving section 120 of the electrical equipment 100, providing reliable metering of power consumption. Furthermore, the crown spring connectors contribute to the overall durability and longevity of the electricity meter 10 by minimizing wear and tear on the connection points, which can be a critical factor in maintaining accurate and consistent metering performance over extended periods.

Additionally, the printed circuit board PCB within the meter casing 20 comprises orifices 71, 72, 73, 74, 75, 76, 77, which are configured to be penetrated by the neutral connection terminal 138, input phase connection terminals 140, 142, 144, and output phase connection terminals 141; 143, 145 of the electrical equipment 100. The connection terminals 140, 141, 142, 143, 144, 145 are positioned coaxially with these orifices71, 72, 73, 74, 75, 76, 77 and protrude through them, ensuring proper alignment and connection.

The connection terminals are soldered to the PCB on the side 31 facing away from the back surface 24 and the receiving surface 122 of the electrical equipment 100, further securing the connections. The connection terminals 140, 141, 142, 143, 144, 145 protrude from a side 33 of the PCB facing the back surface 24 and the receiving surface 122 through the orifices 71, 72, 73, 74, 75, 76, 77 towards the side 31 of the PCB facing away from the back surface 24 and the receiving surface 122.

Overall, Figure 4 provides a detailed back view of the electricity meter 10, highlighting its various components and their configurations, ensuring proper installation and operation within the receiving section 120 of the electrical equipment 100.

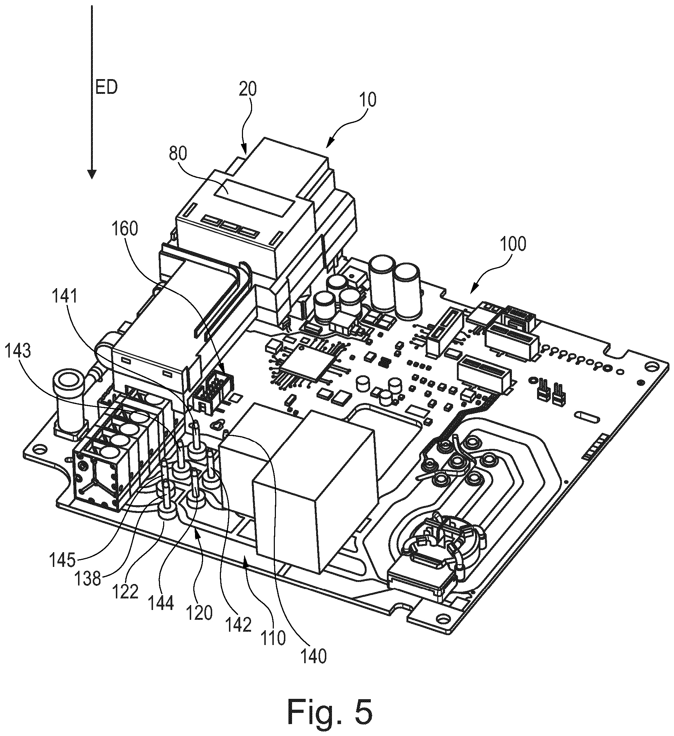

Figure 5 depicts an exploded view of the embodiment of the electricity meter 10 integrated within the electrical equipment 100. The receiving section 120 of the electrical equipment 100 includes the receiving surface 122, which provides a structural interface for the meter casing 20. The engagement direction ED indicates the linear motion required for installation, which is substantially orthogonal to the receiving surface 122.

The meter casing 20 contains the printed circuit board PCB 30, which serves as the foundation for various components contributing to the electricity meter's 10 operation. The PCB 30 is populated with a processing unit, which is responsible for executing metering functions and processing data from sensors.

The electrical equipment 100 comprises a printed circuit board (PCB) 110 to which the neutral connection terminal 138, the input phase connection terminals 140, 142, 144 and the output phase connection terminals 141, 143, 145 are soldered to.

As shown in Figure 5, the data connection interface 60 of the electricity meter 10 is designed to connect to the corresponding data connection interface 160 of the electrical equipment 100 by the same linear motion in the engagement direction ED.

In summary, Figure 5 provides a detailed schematic of the electricity meter 10 and its integration within the electrical equipment 100, showcasing the structural and functional components necessary for effective connectivity. The design emphasizes ease of installation, reliable electrical connections, and efficient data communication, making it suitable for applications such as electric vehicle supply equipment EVSE.

Figures 6 and 7 show cross sectional views of the electricity meter 10 installed in the receiving section 120. The support section of the meter casing 20 rests against the receiving surface 122 when installed. The engagement direction ED is indicated, showing the linear motion required for installation.

Figure 6 shows the neutral meter connection terminal 38 of the electricity meter 10 connected to the neutral connection terminal 138, the input phase meter connection terminals 40, 42, 44 of the electricity meter 10 connected to the input phase connection terminals 140, 142, 144 and the output phase meter connection terminals 41, 43, 45 of the electricity meter 10 connected to the output phase connection terminal 141, 143, 145.

As depicted in figures 6 and 7, the neutral meter connection terminal 38 and input phase meter connection terminals 40, 42, 44 are positioned coaxially with their respective orifices 71, 73, 75, 77 on the PCB 30. Additionally, the output phase meter connection terminals 41, 43, 45 are positioned coaxially with their respective orifices 72, 74, 76. These terminals are configured as crown spring connectors, which allow for secure electrical connections when engaged with the corresponding connection terminals of the electrical equipment 100. The connection terminals 140, 141, 142, 143, 144, 145, 146 of the electrical equipment 100 are each formed by a connection pin extending in a direction which is parallel to the engagement direction ED, facilitating the linear motion required for installation. In the installed position of the electricity meter 10 in the electrical equipment 100 depicted in figure 6, the connection pins are housed in the crown spring connectors. The meter connection terminals 40, 41, 42, 43, 44, 45, 46 are soldered to the PCB 30 on the side 31 facing away from the back surface 24 of the meter casing 20. The connection terminals 140, 141, 142, 143, 144, 145, 146 of the electrical equipment 100 are each soldered to the PCB 110 of the electrical equipment 100.

The PCB 30 depicted in figures 6 and 7 also shows the processing unit 32, which is soldered to the PCB 30 and responsible for processing the metering data. The meter data connection interface 60, which is preferably arranged on the back surface 24, is configured to connect to a data connection interface 160 of the electrical equipment 100 through the same linear motion in the engagement direction ED.

The electricity meter 10 is designed with a focus on ease of installation and reliability, utilizing crown spring connectors for the connection terminals, which offer flexibility and durability. The linear motion installation mechanism ensures that the meter can be easily integrated into the electrical equipment 100 without the need for complex adjustments or configurations.

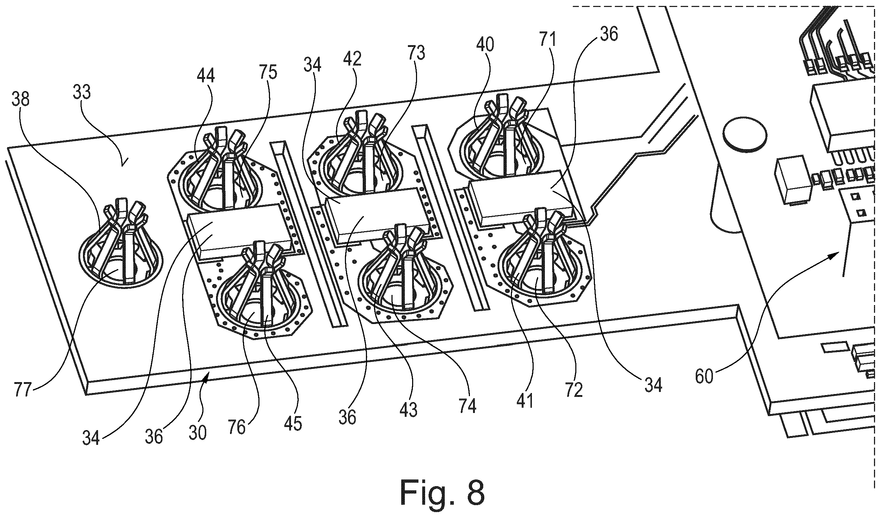

Figure 8 depicts the part of the PCB 30 of the electricity meter 10 where the meter connection terminals 38, 40, 41, 42, 43, 44, 45 and the orifices 71, 72, 73, 74, 75, 76, 77 are positioned. The orifices 71, 72, 73, 74, 75, 76, 77 are configured to be penetrated by corresponding connection terminals 138, 140, 141, 142, 143, 144, 145 of the electrical equipment 100. These orifices71, 72, 73, 74, 75, 76, 77 align with the neutral connection terminal 138, input phase connection terminals 140, 142, 144, and output phase connection terminals 141, 143, 145 of the electrical equipment 100. The neutral meter connection terminal 38, input phase meter connection terminals 40, 42, 44, and output phase meter connection terminals 41, 43, 45 are positioned coaxially with their respective orifices and are designed to protrude through these orifices when the electricity meter 10 is installed in the receiving section 120 of the electrical equipment 100.

The neutral meter connection terminal 38, input phase meter connection terminals 40, 42, 44, and output phase meter connection terminals 41, 43, 45 are formed as crown spring connectors, ensuring a secure and reliable electrical connection. These terminals are soldered to the PCB 30 on the side 31 facing away from the back surface 24 of the meter casing 20 and the receiving surface 122 of the electrical equipment 100.

The figure also depicts the at least one voltage sensor 34 and the at least one current sensor 36 housed within the meter casing 20. The current sensor 36 is implemented as an ammeter shunt, which is a precise method for measuring current flow. These sensors 34, 36 are allow for detecting and measuring the electrical parameters necessary for accurate power consumption metering.

Additionally, Figure 8 shows the meter data connection interface 60, which is configured to be connected to the data connection interface 160 of the electrical equipment 100. This connection is established by the same linear motion in the engagement direction ED towards the receiving section 120, ensuring that both electrical and data connections are made simultaneously during installation.

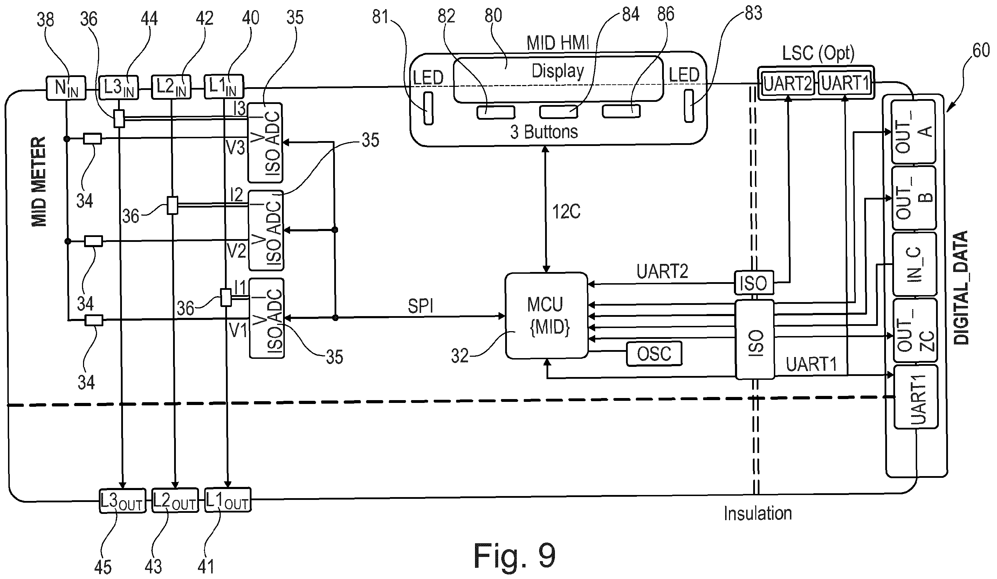

Figure 9 illustrates the schematic diagram of the electricity meter 10 according to the embodiment. The diagram provides a detailed view of the components and their interconnections within the system.

The electricity meter comprises the processing unit 32, identified as MCU3 MID, which serves as the central control unit. This processing unit 32 is responsible for managing data acquisition and processing from various sensors and interfaces. It is connected to multiple components via communication protocols such as UART1, UART2, and I2C, ensuring efficient data transmission and control.

Voltage sensors 34 and current sensors 36 are integrated into the system to measure the electrical parameters necessary for metering. These sensors are connected to the processing unit 32 via the analog to digital converter 35, allowing it to receive real-time data regarding voltage and current levels. The sensors 34, 36 are linked to input phase meter connection terminals 40, 42, and 44, as well as output phase meter connection terminals 41, 43, and 45. These terminals facilitate the connection of the meter to the electrical equipment, enabling accurate measurement of power consumption.

The schematic also includes a neutral meter connection terminal 38, which is connected to the neutral line of the electrical equipment 100. This connection ensures the proper functioning of the meter and the accuracy of the measurements.

A display unit 80 is incorporated into the system, providing a user interface for monitoring power consumption. The display is equipped with three buttons 82, 84, 86 for user interaction, allowing for navigation and configuration of the meter settings. Additionally, LEDs 81 and 83 are present to indicate operational status and provide visual feedback to the user.

The meter data connection interface 60 is shown at the top of the diagram, labeled as "DIGITAL DATA." This interface is designed for digital communication with external devices or systems, enabling the transmission of metering data for further processing or analysis.

The diagram is divided into sections by dashed lines labeled "Insulation," indicating areas of electrical isolation within the system. This design feature ensures safety and prevents interference between different components.

Overall, Figure 9 provides a comprehensive view of the electricity meter's 10 architecture, highlighting the integration of sensors 34, 36, processing units 32, user interfaces, and connection terminals 38, 40, 41, 42, 43, 44, 45. The schematic emphasizes the linear motion connection mechanism, allowing for straightforward installation and engagement with the receiving section of the electrical equipment. This design facilitates ease of use and maintenance, making the meter suitable for various applications in power consumption metering.

## Claims

1. Electricity meter for metering a single phase power consumption or a three-phase power consumption of an electrical equipment (100), more particularly of an electric vehicle supply equipment (EVSE) and configured to be installed in a receiving section (120) of the electrical equipment (100), the electricity meter (10) comprising a meter casing (20), a printed circuit board (PCB) (30) housed in the meter casing (20), a processing unit (32) soldered to the PCB (30), at least one voltage sensor (34) housed in the meter casing (20), at least one current sensor (36) housed in the meter casing (20), a neutral meter connection terminal (38) configured to be connected to a neutral connection terminal (138) of the electrical equipment (100) , at least one input phase meter connection terminal (40, 42, 44) configured to be connected to an input phase connection terminal (140, 142, 144) of the electrical equipment (100) and at least one output phase meter connection terminal (41, 43, 45) configured to be connected to an output phase connection terminal (141, 143, 145) of the electrical equipment (100), **characterized in that** the neutral meter connection terminal (38), the input phase meter connection terminal (40, 42, 44) and the output phase meter connection terminal (41, 43, 45) are configured to be connected to the neutral connection terminal (138), the input phase connection terminal (140, 142, 144) and the output phase connection terminal (141, 143, 145) of the electrical equipment (100) respectively by a linear motion of the electricity meter (10) in an engagement direction (ED) towards the receiving section (120).

2. Electricity meter according to claim 1, the receiving section (120) of the electrical equipment (100) comprising a receiving surface (122), **characterized in that** the meter casing (20) comprises a support section configured to rest against the receiving surface (122) when the electricity meter (10) is installed in the receiving section (120), the meter casing (20) preferably comprising a back surface (24) from which the support section protrudes in the engagement direction (ED), the engagement direction (ED) being substantially orthogonal to the receiving surface (122) and/or the back surface (24).

3. Electricity meter according to claim 1 or 2, **characterized by** a meter data connection interface (60) configured to be connected to a data connection interface (160) of the electrical equipment (100) by the same linear motion of the electricity meter (10) in the engagement direction (ED) towards the receiving section (120), the meter data connection interface (60) being preferably arranged on the back surface (24).

4. Electricity meter according to any one of the claims 1 to 3, **characterized in that** the neutral meter connection terminal (38), the input phase meter connection terminal (40, 42, 44) and the output phase meter connection terminal (41, 43, 45) are housed in the meter casing (20).

5. Electricity meter according to any one of the claims 1 to 4, **characterized in that** the meter casing (20), preferably the back surface (24) of the meter casing (20), comprises at least one opening (51, 52, 53, 54, 55, 56, 57) configured to be penetrated by at least one of the neutral connection terminal (138), the input phase connection terminal (140, 142, 144) and/or the output phase connection terminal (141, 143, 145) of the electrical equipment (100) when the electricity meter (10) is installed in the receiving section (120), the neutral meter connection terminal (38), the input phase meter connection terminal (40, 42, 44) and the output phase meter connection terminal (41, 43, 45) being configured to be electrically connected to the neutral connection terminal (138), the input phase connection terminal (140, 142, 144) and the output phase connection terminal (141, 143, 145) of the electrical equipment (100) respectively when the electricity meter (10) is installed in the receiving section (120).

6. Electricity meter according to any one of the claims 1 to 5, **characterized in that** the neutral meter connection terminal (38), the input phase meter connection terminal (40, 42, 44) and/or the output phase meter connection terminal (41, 43, 45) is/are formed as crown spring connector(s).

7. Electricity meter according to any one of the claims 1 to 6, **characterized in that** the PCB (30) comprises at least three orifices (71, 72, 73, 74, 75, 76, 77) configured to be penetrated by the neutral connection terminal (138), by the input phase connection terminal (140, 142, 144) and by the output phase connection terminal (141, 143, 145) of the electrical equipment (100) when the electricity meter (10) is installed in the receiving section (120).

8. Electricity meter according to a combination of claims 6 and 7, **characterized in that** the neutral meter connection terminal (38), the input phase meter connection terminal (40, 42, 44) and the output phase meter connection terminal (41, 43, 45) are positioned coaxially with the corresponding orifice (71, 72, 73, 74, 75, 76, 77).

9. Electricity meter according to any one of the claims 7 or 8, **characterized in that** the neutral meter connection terminal (38), the input phase meter connection terminal (40, 42, 44) and/or the output phase meter connection terminal (41, 43, 45) protrude(s) through its corresponding orifice (71, 72, 73, 74, 75, 76, 77).

10. Electricity meter according to any one of the claims 1 to 9, **characterized in that** the neutral meter connection terminal (38), the input phase meter connection terminal and/or the output phase meter connection terminal (41, 43, 45) is/are soldered to the PCB (30) on a side (31) of the PCB (30) facing away from the back surface (24) and/or facing away from the receiving surface (122) of the electrical equipment (100).

11. Electricity meter according to any one of the claims 1 to 10, **characterized by** a screen (80) configured to display the power consumption, the screen (80) being arranged on the meter casing (20).

12. Electricity meter according to any one of the claims 1 to 11, **characterized in that** the current sensor (36) is an ammeter shunt.

13. Electrical equipment, more particularly an electric vehicle supply equipment (EVSE) comprising an electricity meter (10) according to any one of the claims 1 to 12, a receiving section (120), a neutral connection terminal (138), at least one input phase connection terminal (140, 142, 144) and at least one output phase connection terminal (141, 143, 145), the electricity meter (10) being installed in the receiving section (120), the neutral meter connection terminal (38) of the electricity meter (10) being connected to the neutral connection terminal (138), the input phase meter connection terminal (40, 42, 44) of the electricity meter (10) being connected to the input phase connection terminal (140, 142, 144) and the output phase meter connection terminal (41, 43, 45) of the electricity meter (10) being connected to the output phase connection terminal (141, 143, 145).

14. Electrical equipment according to claim 13, **characterized in that** the neutral connection terminal (138), the input phase connection terminal (140, 142, 144) and the output phase connection terminal (141, 143, 145) are each formed by a connection pin extending in a direction which is parallel to the engagement direction (ED).

15. Electrical equipment according to claim 14, **characterized in that** the neutral connection terminal (138), the input phase connection terminal (140, 142, 144) and the output phase connection terminal (141, 143, 145) are each soldered to a printed circuit board (PCB) (110) of the electrical equipment (100).
